# EUROPÄISCHE PATENTSCHRIFT

(11) **EP 1 776 003 B1**
(45) Veröffentlichungstag und Bekanntmachung des Hinweises auf die Patenterteilung: **01.10.2014**
(21) Anmeldenummer: 06021464.0
(22) Anmeldetag: 13.10.2006
(51) Int. Cl.: H05K 3/20, H05K 1/09, H05K 3/24, E05B 81/00, E05B 85/02

(54) **Kraftfahrzeugtürverschluss**
Car door lock
Serrure d'un portière de véhicule automobile

(30) Priorität: 17.10.2005 DE 102005049975
(43) Veröffentlichungstag der Anmeldung: 18.04.2007
(73) Patentinhaber: Kiekert Aktiengesellschaft, 42579 Heiligenhaus (DE)
(72) Erfinder: Handke, Armin, 47269 Duisburg (DE); Mader, Martin, 45259 Essen (DE)
(74) Vertreter: Gille Hrabal

(56) Entgegenhaltungen:
- DE-A1- 3 804 558
- DE-A1- 10 344 121
- DE-A1- 19 627 481
- DE-B3- 10 328 005
- DE-U1- 8 912 914
- DE-U1- 20 307 111
- GB-A- 1 532 212
- RU-C1- 2 212 456
- US-A- 5 822 849

## Beschreibung

Die Erfindung betrifft einen Kraftfahrzeugtürverschluss einem Komponententräger mit wenigstens einem Basiselement und wenigstens einem Leiterbahngebilde. Das Lelterbahngebilde dient der Verbindung von elektrisch ansteuerbaren Bauelementen. Ein solcher Kraftfahrzeugtürverschluss mit Elektrokomponententräger geht aus der Druckschrift DE 203 07 111 U1 hervor.

Üblicherweise sind derartige Komponententräger Teil elektrischer Schaltungsanordnungen, wie sie heutzutage in vielerlei elektrischen Geräten Verwendung finden. Gerade bei solchen Schaltungsanordnungen, die in Kraftfahrzeugen eingebaut sind, wie beispielsweise Schließvorrichtungen für eine Seitentür, eine Heckklappe, eine Motorhaube oder dergleichen, müssen hohe Anforderungen hinsichtlich der Kompaktheit und der Dauerbelastbarkeit erfüllt werden. Dies ist insbesondere mit den auftretenden Umgebungsbedingungen zu begründen, wie zum Beispiel ein extreme Außentemperatur und/oder Luftfeuchtigkeit, starke Schwankungen von Außentemperatur und/oder Luftfeuchtigkeit, in der Umgebungsluft befindliche Schmutzpartikel oder auch beachtliche mechanische Vibrationen bzw. Stoßbeanspruchung dieser elektrischen Schaltungsanordnungen.

Das Leiterbahngebilde dient dabei regelmäßig zur Herstellung elektrischer Verbindungen, die beispielsweise zur Ansteuerung bzw. zum Betreiben von elektrischen Bauteilen erforderlich sind. Bekannt ist ein solches Leiterbahngebilde aus Draht oder Blechformteilen herzustellen, wobei derzeit regelmäßig auf Messing und/oder Bronze zurückgegriffen wird. Weiterhin ist auch bekannt, elektrisch leitfähigen Kunststoff einzusetzen.

Die vorliegenden Lösungen können teilweise den Umgebungsbedingungen nicht genügen, sind teilweise nur mit beachtlichem Kostenaufwand herstellbar und/oder konnen teilweise keine dauerhafte elektrische Verbindung von Bauteilen im Bereich des Turschlosses bzw einer Kraftfahrzeugtur gewährleisten

Leiterbahngebilde sind aus den Druckschriften DE 196 27 481 A1 sowie DE 89 12 914 U1 bekannt.

Aufgabe der vorliegenden Erfindung ist es, die mit den Ausführungen des Stands der Technik auftretenden technischen Probleme zumindest teilweise zu mindern und insbesondere eine kostengünstigere und robustere sowie effektivere Ausgestaltung eines solchen Komponententragers anzugeben.

Diese Aufgabe wird gelost mit einem Kraftfahrzeugturverschluss gemaß den Merkmalen des Patentanspruchs 1. Weitere vorteilhafte Ausgestaltungen sind in der nachfolgenden Beschreibung naher etläutert. Es ist darauf hinzuweisen, dass alle, nachstehend aufgeführten Merkmale in beliebiger, technologisch sinnvoller Weise mit den Merkmalen aus den Patentansprüchen kombiniert werden können und weitere Ausgestaltungen eines erfindungsgemaßen Komponententrägers angeben

Das Kraftfahrzeugtürverschluss weist wenigstens ein Basiselement und wenigstens ein Leiterbahngebilde auf, und ist dadurch gekennzeichnet, dass das wenigstens eine Leiterbahngebilde zumindest einen metallischen Grundkörper mit einer Oberflache hat, wobei wenigstens eine Oberflache zumindest teilweise eine Zinnschicht aufweist.

Der Kraftfahrzeugturverschluss umfasst wenigstens ein Basiselement und wenigstens ein Leiterbahngebilde, wobei das wenigstens eine Leiterbahngebilde Weißblech umfasst.

Das Basiselement dient insbesondere der Fixierung bzw. Aufnahme des Leiterbahngebildes. Es ist bevorzugt aus einem Kunststoff.

Das Weißblech weist einen metallischen Grundkörper mit einer Oberfläche auf, wobei wenigstens eine Oberfläche zumindest teilweise eine Zinnschicht aufweist.

Unter Weißblech wird ein kalt gewalztes Stahlblech mit einer Dicke von bis zu 0,5 mm verstanden, insbesondere mit einer Dicke von höchstens 0,3 mm. Gekennzeichnet ist das Weißblech durch eine hauchdünne Zinnschicht, die bevorzugt elektrolytisch auf den metallischen Grundkörper aufgebracht ist und weiß schimmert. Damit wird z.B. auch ein Korrosionsschutz bewirkt, so dass das Leiterbahngebilde eine länger Lebensdauer auch bei erhöhter Luftfeuchtigkeit hat. Weiterhin ist auch vorteilhaft, wenn es sich bei dem Leiterbahngebilde um wenigstens ein Stanzteil handelt, da die leicht herzustellen ist und eine gewisse Formsteifigkeit bzw. Robustheit aufweist.

Ganz besonders bevorzugt ist der Einsatz eines Weißblech-Materials mit folgenden Kennwerten: Kaltband St2, T52, BK, Oberfläche stone-Finish, GK, DIN 1544/1624, elektrolytisch verzinnt E 11,2/11,2, RID 400 mm, RAD ca. 800 mm. Zur Erläuterung dieser Kennwerte wird insbesondere auch die Deutschen Industrienormen (DIN) 1544, 1616 und 1624 Bezug genommen, deren Inhalt hier vollumfänglich zum Gegenstand der Beschreibung gemacht wird.

Ebenfalls bevorzugt ist der Einsatz eines metallischen Grundkörpers aus einem Weißblech-Material mit wenigstens einer der folgenden Eigenschaften:
- kaltgewalztes dünnes Band aus Stahl mit blanker Oberfläche mit der Werkstoffbezeichnung 1.0338, gemäß der deutschen DIN-Bezeichung St 4 (DIN 1624) bzw. der europäischen DIN-Bezeichnung DC04 (DIN EN 10139);
- dünnes Stahlband mit einem Kohlenstoffgehalt von höchstens 0,08% (Massenprozent), einem Mangangehalt von höchstens 0,4%, einen Phosphorgehalt von höchstens 0,03%, einen Schwefelgehalt von höchstens 0,03% sowie ggf. erhebliche Anteile von Titan und/oder Bohr, wobei insbesondere keine relevanten Anteile von Chrom, Molybdän, Nickel und/oder Silizium vorgesehen sind (tatsächlich auftretende Verunreinigungen lassen die obigen Ausführungen unberührt).

Ganz besonders bevorzugt handelt es sich bei dem metallischen Grundkörper um einen weichen, unlegierten Stahl.

Das Weißblech hat bevorzugt einen Härtegrad im Bereich von 48 HR bis 56 HR (Härte Rockwell).

Insbesondere erfolgt die Aufbringung der Zinnschicht beidseitig auf beiden Oberflächen mit einer Schichthöhe von mindestens 5 µm, insbesondere 8 µm und bevorzugt mindestens 10 µm. Dabei ist die Schichtdicke auf beiden Oberflächen des Grundkörpers bevorzugt gleich, dies ist jedoch nicht zwingend erforderlich.

Die Zinnschicht weist bevorzugt mindestens 99,75 Gew. % Zinn auf.

Die elektrische Leitfähigkeit des Leiterbahngebildes liegt bevorzugt in einem Bereich von 5 bis 10 m/(Ω*mm²) (Meter/(Ohm * Quadratmillimeter)), insbesondere zwischen 7 und 8 m/(Ω*mm²).

Das Leiterbahngebilde hat dabei bevorzugt eine Leiterlänge, die höchstens so lang gewählt ist, dass ein Spannungsabfall von höchstens 0,07 V (Volt) über die Leiterlänge festzustellen ist.

Die Erfindung findet Anwendung in einem Schließsystem eines Kraftfahrzeuges, wie zum Beispiel einem Türschloss bei einem Automobil.

Die Erfindung sowie das nähere technische Umfeld werden anhand der beiden Figuren erläutert. Es zeigen:
Fig. 1: eine schematische Darstellung eines Komponententrägers, und
Fig. 2: einen Detailausschnitt aus einem Leiterbahngebilde.

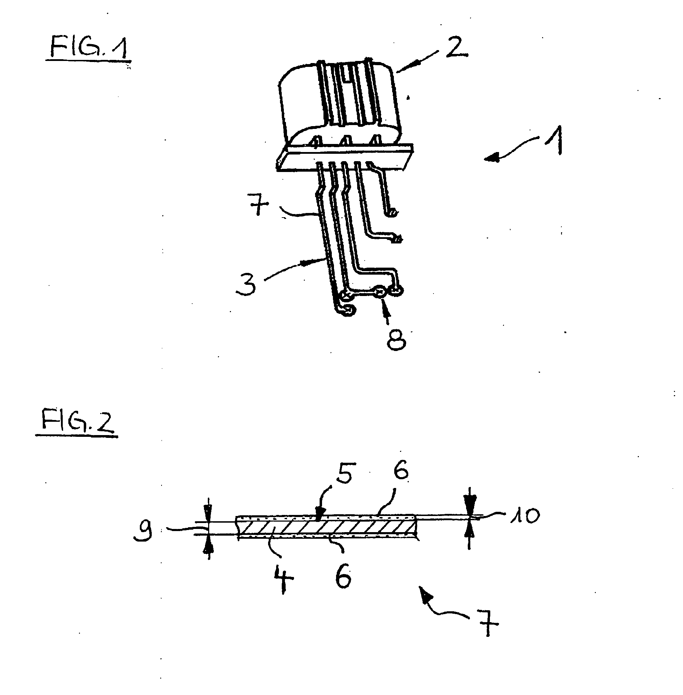

Die Fig. 1 zeigt einen Komponententräger 1, der ein Basiselement 2 umfasst, welches mit einem Leiterbahngebilde 3 verbunden ist. Das Leiterbahngebilde 3 umfasst eine Mehrzahl von Anschlüssen 8, zur elektrischen Kontaktierung weiterer Bauteile. Der Komponententräger 1 ist Teil eines Kraftfahrzeugtürschlosses, wobei das Leiterbahngebilde 3 mit elektrischen Komponenten eines Kraftfahrzeugtürschlosses verbunden ist. Das Leiterbahngebilde 3 ist mit Weißblech 7 ausgeführt.

Fig. 2 zeigt im Schnitt ein Detail durch das Leiterbahngebilde 3. Das Leiterbahngebilde 3 umfasst einen metallischen Grundkörper 4, Stahl mit einer Dicke 9 kleiner 0,5 mm. Auf den Oberflächen 5 des Grundkörpers 4 ist jeweils eine Zinnschicht 6 vorgesehen, die mit einer Höhe 10 im Bereich von 10 µm bis 12 µm ausgeführt ist.

## Patentansprüche

1. Kraftfahrzeugtürverschluss mit einem Schlossgehäuse aufweisend wenigstens ein Basiselement (2) und wenigstens ein Leiterbahngebilde (3), wobei das Basiselement (2) eine Aufnahme des Leiterbahngebildes (3) bildet und aus Kunststoff ist, wobei das Leiterbahngebilde mit elektrischen Komponenten des Kraftfahrzeugtürverschlusses verbunden ist, wobei es sich bei dem Leiterbahngebilde um ein Stanzteil handelt, **dadurch gekennzeichnet, dass** das Leiterbahngebilde (3) mit Weißblech ausgeführt ist und zwar ein kalt gewalztes Stahlblech (4) mit einer Dicke von bis zu 0,5 mm und einer weiß schimmernden, hauchdünnen Zinnschicht.

2. kraftrahrzeugtürverschluss nach Patentanspruch 1, wobei das Leiterbahngebilde einen metallischen Grundkörper (4) umfasst, der ein dünnes Stahlband mit einem Kohlenstoffgehalt von höchstens 0.08%, einem Mangangehalt von höchstens 0,4%, einen Phosphorgehalt von höchstens 0,03% und einen Schwefelgehalt von höchstens 0.03% umfasst.

3. Kraftfahrzeugtürverschfuss nach einem der vorhergehenden Patentansprüche, wobei das Leiterbahngebilde (3) eine Zinnschicht (6) mit einer Höhe (10) von mindestens 5 µm aufweist.

4. Kraftfahrzeugtürverschluss nach einem der vorhergehenden Patentansprüche, wobei das Leiterbahngebilde (3) eine elektrische Leitfähigkeit in einem Bereich von 5 bis 10 M/(Ω*mm²) hat.

## Claims

1. A car door lock having a lock housing comprising at least one base element (2) and at least one conductor path formation (3), wherein the base element (2) forms a receiver of the conductor path formation (3) and is made of plastic, wherein the conductor path formation is connected to electric components of the car door lock, wherein the conductor path formation is a punched part, **characterized in that** the conductor path formation (3) is made with tinplate, i.e. a cold rolled steel sheet (4) having a thickness of up to 0.5 mm and comprising a filmy tin layer that is shimmering white.

2. A car door lock according to claim 1, wherein the conductor path formation comprises a metallic base body (4) which includes a thin steel band comprising a carbon content of not more than 0.08 %, a manganese content of not more than 0.4 %, a phosphorous content of not more than 0.03 % and a sulphur content of not more than 0.03 %.

3. A car door lock according to one of the preceding claims, wherein the conductor path formation (3) comprises a tin layer having a height (10) of at least 5 µm.

4. A car door lock according to one of the preceding claims, wherein the conductor path formation (3) has an electric conductivity in a range comprised between 5 and 10 m/(Ω*mm²).

## Revendications

1. Fermeture de porte de véhicule automobile comprenant un boîtier de serrure comprenant au moins un élément de base (2) et au moins un ensemble de pistes conductrices (3), l'élément de base (2) formant un logement de l'ensemble de pistes conductrices (3) et étant fabriqué en plastique, l'ensemble de pistes conductrices étant relié à des composants électriques de la fermeture de porte de véhicule automobile, l'ensemble de pistes conductrices étant une pièce découpée, **caractérisée en ce que** l'ensemble de pistes conductrices (3) est réalisé avec du fer blanc, i.e. en tôle d'acier (4) laminée à froid ayant une épaisseur de jusqu'à 0,5 mm et comprenant une couche d'étain très fine d'un blanc brillant.

2. Fermeture de porte de véhicule automobile selon la revendication 1, dans laquelle l'ensemble de pistes conductrices comprend un corps de base (4) métallique qui comprend une bande d'acier mince ayant une teneur en carbone d'au plus 0,08 %, une teneur en manganèse d'au plus 0,4 %, une teneur en phosphore d'au plus 0,03 % et une teneur en soufre d'au plus 0,03 %.

3. Fermeture de porte de véhicule automobile selon l'une des revendications précédentes, dans laquelle l'ensemble de pistes conductrices (3) comprend une couche d'étain (6) ayant une hauteur (10) d'au moins 5 µm.

4. Fermeture de porte de véhicule automobile selon l'une des revendications précédentes, dans laquelle l'ensemble de pistes conductrices (3) a une conductivité électrique dans une gamme comprise entre 5 et 10 m/(Ω*mm²).
